(19)

Europäisches
Patentamt
European
Patent Office
Office européen
des brevets

(11) **EP 2 882 154 A1**

(12) **EUROPEAN PATENT APPLICATION**

(43) Date of publication:
**10.06.2015 Bulletin 2015/24**

(51) Int Cl.:
**H04L 25/03** (2006.01) **H03F 1/32** (2006.01)

(21) Application number: **13306655.5**

(22) Date of filing: **03.12.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **ALCATEL LUCENT
92100 Boulogne-Billancourt (FR)**

(72) Inventor: **Cabezas Lopez, Meritxell
70435 Stuttgart (DE)**

(74) Representative: **Hofmann, Dirk et al
Alcatel-Lucent Deutschland AG
Intellectual Property Business Group
Lorenzstrasse 10
70435 Stuttgart (DE)**

Remarks:
Amended claims in accordance with Rule 137(2)
EPC.

(54) **Transmitter method for transmitting radio frequency signals from multiple antenna elements,
receiver method, transmitter apparatus, receiver apparatus and network node thereof**

(57) The embodiments of the invention relate to a transmitter method (TRA-MET) for transmitting radio frequency signals from multiple antenna elements. The transmitter method contains the steps of encoding (TRA-S2-1) with a first coding a first signal before being processed by a first pre-distortion and amplification unit, encoding (TRA-S2-2, ..., TRA-S2-N) with at least one second coding at least one second signal before being processed by at least one second pre-distortion and amplification unit, processing (TRA-S3-1) the first encoded signal by the first pre-distortion and amplification unit for obtaining a first amplified pre-distorted encoded signal, processing (TRA-S3-2, ..., TRA-S3-N) the at least second encoded signal by the at least second pre-distortion and amplification unit for obtaining at least one second amplified pre-distorted encoded signal, and outputting (TRA-S4-1) the first amplified pre-distorted encoded signal as a first transmit signal to a first transmit antenna element, and outputting (TRA-S4-2, ..., TRA-S4-N) the at least one second amplified pre-distorted encoded signal as at least one second transmit signal to at least one second transmit antenna element. The embodiments further relate to a receiver method for radio frequency signals being transmitted from multiple antenna elements. The receiver method contains the steps of receiving as a first received signal a first transmit signal being encoded by a first coding for a first pre-distortion and amplification unit and being transmitted by a first transmit antenna element, receiving as at least one second received signal at least one second transmit signal being encoded by at least one second coding for at least one second pre-distortion and amplification unit and being transmitted by at least one second transmit antenna element, a first decoding of the first received transmit signal for reversing the first coding and at least one second decoding of the at least second received transmit signal for reversing the at least one second coding. The embodiments of the invention even further relate to a transmitter apparatus, to a receiver apparatus and to a network node, which contains the transmitter apparatus and/or the receiver apparatus.

FIG. 2

**Description**

**FIELD OF THE INVENTION**

The present invention relates to radio transmission via multiple antenna elements and, more particularly but not exclusively, to encoding and digital pre-distortion in a transmitter apparatus being connected to the multiple antenna elements.

**BACKGROUND**

This section introduces aspects that may be helpful in facilitating a better understanding of the invention. Accordingly, the statements of this section are to be read in this light and are not to be understood as admission about what is in the prior art.

Several RF PAs (RF = Radio Frequency, PA = Power Amplifier) are used in a transmitter apparatus for radio communication for providing radio frequency signals with a sufficient transmit power to an antenna array and for being able to receive the radio frequency signals at a receiver apparatus with a sufficient SNR (SNR = Signal-to-Noise Ratio). Operating such an RF PA without any corrective measures results in the well-known problem that a non-linearity of a gain of the RF PA generate disturbing signals such as IM products (IM = Inter Modulation), which may interfere with data signals and which may be even located outside a licensed frequency band. Advanced transmission systems based on OFDM (OFDM = Orthogonal Frequency Division Multiplexing) or WCDMA (WCDMA = Wideband Code Division Multiple Access) are especially vulnerable to such nonlinear distortions. To overcome such nonlinear distortions, linearization modules such as DPD units (DPD = Digital PreDistortion) are usually applied in transmitter apparatuses of every radio communication system. Such a linearization module estimates a gain characteristic of the RF PA based on measured feedback signals from an output of the RF PA.

In MIMO and beamforming applications (MIMO = Multiple Input Multiple Output) two or more transmit antenna elements of an antenna array transmit radio frequency signals at a same RF frequency. If isolation between an i-th processing path for an i-th transmit antenna element and to its neighboring i-1-th and i+1-th processing paths for i-1-th and i+1-th transmit antenna elements is larger than 25 dB, which is usual in real applications, feedback signals of i-1-th and i+1-th linearization modules of the neighboring i-1-th and i+1-th processing paths may be coupled to feedback signals of an i-th linearization module of the i-th processing path. Since a pre-distorter performance highly depends on a quality of the feedback signals, a feedback loop may significantly degrade a linearity of a gain of an RF PA of the i-th processing path and consequently may decrease an efficiency of the RF PA, when such a coupling in a transmitter apparatus for an antenna array occurs. Furthermore, the i-th linearization module may not be able to completely suppress the distortion based on the coupling and IM products may even occur when DPD is applied.

**SUMMARY**

Thus, an object of the embodiments of the invention is to provide an improved radio communication between a transmitter apparatus being connected to an antenna array and a receiver apparatus.

The object is achieved by a transmitter method for transmitting radio frequency signals from multiple antenna elements. The transmitter method contains the steps of encoding with a first coding a first signal before being processed by a first pre-distortion and amplification unit and encoding with at least one second coding at least one second signal before being processed by at least one second pre-distortion and amplification unit. The transmitter method further contains the steps of processing the first encoded signal by the first pre-distortion and amplification unit for obtaining a first amplified pre-distorted encoded signal and processing the at least second encoded signal by the at least second pre-distortion and amplification unit for obtaining at least one second amplified pre-distorted encoded signal. The transmitter method even further contains the steps of outputting the first amplified pre-distorted encoded signal as a first transmit signal to a first transmit antenna element and outputting the at least one second amplified pre-distorted encoded signal as at least one second transmit signal to at least one second transmit antenna element.

The object is further achieved by a receiver method for radio frequency signals being transmitted from multiple antenna elements. The receiver method contains the step of receiving a first transmit signal being encoded by a first coding for a first pre-distortion and amplification unit and being transmitted by a first transmit antenna element and at least one second transmit signal being encoded by at least one second coding for at least one second pre-distortion and amplification unit and being transmitted by at least one second transmit antenna element. The receiver method further contains a first decoding of the first received transmit signal for reversing the first coding and at least one second decoding of the at least second received transmit signal for reversing the at least one second coding.

The object is even further achieved by a transmitter apparatus for transmitting radio frequency signals from multiple antenna elements. The transmitter apparatus contains means for encoding with a first coding a first signal before being processed by a first pre-distortion and amplification unit and means for encoding with at least one second coding at least one second signal before being processed by at least one second pre-distortion and amplification unit. The transmitter apparatus further contains the first pre-distortion and amplification unit for processing the first encoded signal and for obtaining a first amplified pre-distorted encoded signal and the at least one second pre-distortion and amplification unit for processing the at least second encoded signal and for obtaining at least one second amplified pre-distorted encoded signal. The transmitter apparatus further contains means for outputting the first amplified pre-distorted encoded signal as a first transmit signal to a first transmit antenna element and means for outputting the at least one second amplified pre-distorted encoded signal as at least one second transmit signal to at least one second transmit antenna element.

In embodiments, the means for encoding may correspond to any encoding unit, coding module, coder, encoder etc. Hence, in embodiments the means for encoding may contain an input for the first signal or the at least one second signal, an algorithm, which encodes the first signal with the first coding or the at least one second signal with the at least one second coding, and an output for the first encoded signal or the at least one second encoded signal. In some embodiments the means for encoding can be implemented in terms of a computer program and a hardware component on which the computer program is executed, such as a DSP (DSP = Digital Signal Processor), an ASIC (ASIC = Application-Specific Integrated Circuit), an FPGA (FPGA = Field-Programmable Gate Array) or any other processor.

The first pre-distortion and amplification unit and the at least second pre-distortion and amplification unit may each contain means for pre-distortion, means for amplification and means for feeding back.

In embodiments, the means for pre-distortion may correspond to any pre-distorting unit, per-distortion module, pre-distorter etc. Hence, in embodiments the means for pre-distortion may contain an input for one of the first or the at least one second encoded signal and for a feedback signal being a part of the first or the at least one second amplified pre-distorted encoded signal, an algorithm, which pre-distorts the first or the at least one second encoded signal, and an output for the first or the at least one second pre-distorted encoded signal. In some embodiments the means for pre-distortion can be implemented in terms of a computer program and a hardware component on which the computer program is executed, such as a DSP, an ASIC, an FPGA or any other processor.

In embodiments, the means for amplification may correspond to any amplifying unit, amplification module, power amplifier etc. Hence, in embodiments the means for amplifying may contain an input for the first or the at least one second pre-distorted encoded signal, electronic components, which amplify the first or the at least one second pre-distorted encoded signal, and an output for the first or the at least one second amplified pre-distorted encoded signal.

In embodiments, the means for feeding back may correspond to any feedback unit, feedback module, directional coupler etc. Hence, in embodiments the means for feeding back may contain a coupling medium, which allows an extraction of the part of the first amplified pre-distorted encoded signal from the first amplified pre-distorted encoded signal or an extraction of the at least one second amplified pre-distorted encoded signal from the at least one second amplified pre-distorted encoded signal and an output for the part of the first or of the at least one second amplified pre-distorted encoded signal. In some embodiments the means for feeding back can be partly implemented (e.g. an analogue-to-digital converter) in terms of a computer program and a hardware component on which the computer program is executed, such as a DSP, an ASIC, an FPGA or any other processor.

In embodiments, the means for outputting may correspond to any output unit, output module, connector unit, plug module etc. Hence, in embodiments the means for outputting may contain an input for the first or the at least one second amplified pre-distorted encoded signal, a connector unit and electrical lines such as coaxial cables, which conduct the first or the at least one second amplified pre-distorted encoded signal from the output of the means for amplification to the connector unit.

The object is even further achieved by a receiver apparatus for radio frequency signals being transmitted from multiple antenna elements. The receiver apparatus contains means for receiving a first transmit signal being encoded by a first coding for a first pre-distortion and amplification unit and being transmitted from a first transmit antenna element and for receiving at least one second transmit signal being encoded by at least one second coding for at least one second pre-distortion and amplification unit and being transmitted from at least one second transmit antenna element. The receiver apparatus further contains means for a first decoding of the first received transmit signal for reversing the first coding and means for at least one second decoding of the at least second received transmit signal for reversing the at least one second coding.

In embodiments, the means for receiving may correspond to any receiver unit, receiver module, transceiver unit etc. such as an analogue part, which contains an input connector unit connected to a receiving antenna system, a pre-amplifier, a filter unit and an attenuation unit. Hence, in embodiments the means for receiving may contain the input connector unit for the first transmit signal and the at least one second transmit signal being conducted by electrical lines from a receiving antenna system to the input connector unit, components, which filter, pre-amplify and attenuate the received first transmit signal and the received at least one second and which convert the pre-amplified first transmit signal into a first digital signal and the pre-amplified at least one second transmit signal into at least one second digital signal, and an output for the first digital signal and the at least one second digital signal. In some embodiments the means for receiving can be partly implemented in terms of a computer program and a hardware component (e.g. an analogue-to-digital converter) on which the computer program is executed, such as a DSP, an ASIC, an FPGA or any other processor.

In embodiments, the means for the first decoding and the at least one second means for the at least second decoding may correspond to any decoding unit, decoding module, decoder etc. Hence, in embodiments the means for decoding may contain an input for the first digital signal or the at least one second digital signal, an algorithm, which reverses the first coding of the first digital signal for obtaining a first un-coded digital signal or reverses the at least one second coding of the at least one second digital signal for obtaining at least one second un-coded digital signal, and an output for the first un-coded digital signal or the at least one second un-coded digital signal. In some embodiments the means for decoding can be implemented in terms of a computer program and a hardware component on which the computer program is executed, such as a DSP, an ASIC, an FPGA or any other processor.

The object is even further achieved by a network node, which contains the transmitter apparatus and/or the receiver apparatus. The network node may be for example a base station, a repeater, a relay or a mobile station.

The embodiments provide a first advantage of isolating the pre-distortion feedback paths against each other by pre-coding data on each processing path of the transmitter apparatus for one of the transmit antenna elements for example with a matrix, which is orthogonal to all further matrices used for the other processing paths. The embodiments provide a second advantage of avoiding signal distortions such as IM products in the signals being transmitted by the antenna array. The embodiments provide a third advantage of providing a simple and more stable conditioning of transmit signals for antenna arrays.

Further advantageous features of the embodiments of the invention are defined in the dependent claims and are described in the following detailed description.

**BRIEF DESCRIPTION OF THE FIGURES**

The embodiments of the invention will become apparent in the following detailed description and will be illustrated by accompanying figures given by way of non-limiting illustrations.

Figure 1 shows schematically a block diagram of a transmitter apparatus for transmitting radio frequency signals from multiple antenna elements according to an exemplary embodiment.

Figure 2 shows schematically a flow diagram of a transmitter method for transmitting radio frequency signals from multiple antenna elements according to an exemplary embodiment.

Figure 3 shows schematically a block diagram of a receiver apparatus for radio frequency signals being transmitted from multiple antenna elements according to an exemplarily embodiment.

Figure 4 shows schematically a flow diagram of a receiver method for radio frequency signals being transmitted from multiple antenna elements according to an exemplary embodiment.

Figure 5 shows schematically a block diagram of a network node according to an exemplarily embodiment.

**DESCRIPTION OF THE EMBODIMENTS**

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

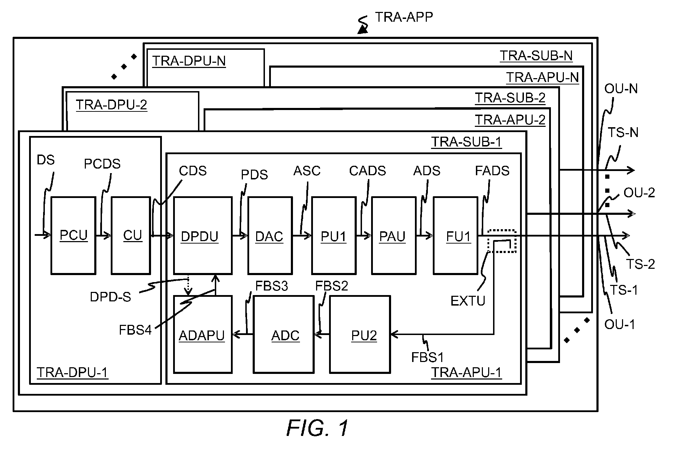

Figure 1 shows schematically a block diagram of a transmitter apparatus TRA-APP, which is adapted for transmitting radio frequency signals from multiple antenna elements. The multiple antenna elements may belong for example to a single antenna array at a single location or may belong to a distributed antenna system, which contains antenna systems at different locations.

A splitting of processing functions across processing units shown in Figure 1 is not critical, and as can be understood by those skilled in the art that the number of processing units, the number of processing functions and an allocation of the processing functions to the processing units may vary without departing from the scope of the embodiments of the invention as defined in the appended claims.

The exemplarily shown transmitter apparatus TRA-APP contains a number *N* of subunits TRA-SUB-1, TRA-SUB-2, ..., TRA-SUB-N. Each of the subunits TRA-SUB-1, TRA-SUB-2, ..., TRA-SUB-N is adapted to provide a transmit signal for a dedicated antenna element. A first subunit TRA-SUB-1 is adapted to provide a first transmit signal TS-1 to a first set of transmit antenna elements, which are not shown for simplification. In a same way, a second subunit TRA-SUB-2 is adapted to provide a second transmit signal TS-2 to a second set of transmit antenna elements, which are also not shown for simplification. An *Nth* subunit TRA-SUB-N may be adapted to provide an *Nth* transmit signal TS-N to an *Nth* set of transmit antenna elements, which are also not shown for simplification. The number *N* of subunits may be for example 2, 4, 8, 16 or even larger. The first set of transmit antenna elements, the second set of transmit antenna elements up to the *Nth* set of transmit antenna elements may have a number of transmit antenna elements such as 1, 2, 4, 8 or even larger. This means that one or more transmit antenna elements send a same forward signal provided by one of the subunits TRA-SUB-1, TRA-SUB-2, ..., TRA-SUB-N.

The following detailed description is given for the embodiment of using an equal number of transmit antenna elements for the first set of transmit antenna elements, second set of transmit antenna elements and so on up to the *Nth* set of transmit antenna elements. A skilled person may easily adapt the description for an alternative embodiment of using different number of transmit antenna elements for the first set of transmit antenna elements, second set of transmit antenna elements and so on up to the *Nth* set of transmit antenna elements.

The first subunit TRA-SUB-1 contains a first digital processing unit TRA-DPU-1 for a digital processing of a first data signal DS of a first data stream for the first antenna element. The first subunit TRA-SUB-1 further contains a first pre-distortion and amplification unit TRA-APU-1 for a digital pre-distortion and amplification of first data provided from the first digital processing unit TRA-DPU-1 and for outputting the first transmit signal TS-1. The first digital processing unit TRA-DPU-1 may be also called DSP domain and the first pre-distortion and amplification unit TRA-APU-1 may be also called RF domain (RF = Radio Frequency). In a same way, the second subunit TRA-SUB-2 contains a second digital processing unit TRA-DPU-2 for a digital processing of a second data stream and contains a second pre-distortion and amplification unit TRA-APU-2 for a digital pre-distortion and amplification of second data provided from the first part TRA-DPU-2 and for outputting the second transmit signal TS-2. Also in a same way, the *Nth* subunit TRA-SUB-N contains an *Nth* digital processing unit TRA-DPU-N for a digital processing of an *Nth* data stream and an *Nth* pre-distortion and amplification unit TRA-APU-N for a digital pre-distortion and amplification of *Nth* data provided from the first part TRA-DPU-N and for outputting the *Nth* transmit signal TS-N.

The first subunit TRA-SUB-1 is described in the following in more detail. The second subunit TRA-SUB-2 up to the *Nth* subunit TRA-SUB-N may have same functional processing units but which are not described in detail for simplification.

The first digital processing unit TRA-DPU-1 of the first subunit TRA-SUB-1 contains a pre-coding unit PCU and a coding unit CU. The pre-coding unit PCU is used for beamforming to support multi-stream (or multi-layer) transmission in multi-antenna wireless communications. In point-to-point systems, pre-coding means that multiple data streams are emitted from the transmit antenna elements with independent and appropriate weightings such that a link throughput is maximized at a receiver output. In multi-user MIMO, the multiple data streams are intended for different users.

Alternatively, the first digital processing unit TRA-DPU-1 of the first subunit TRA-SUB-1 may contain instead of the pre-coding unit PCU a weighting unit for single-stream beamforming, which means that a same signal is emitted from each of the transmit antenna elements with appropriate weighting (phase and gain) such that a signal power is maximized at the receiver output.

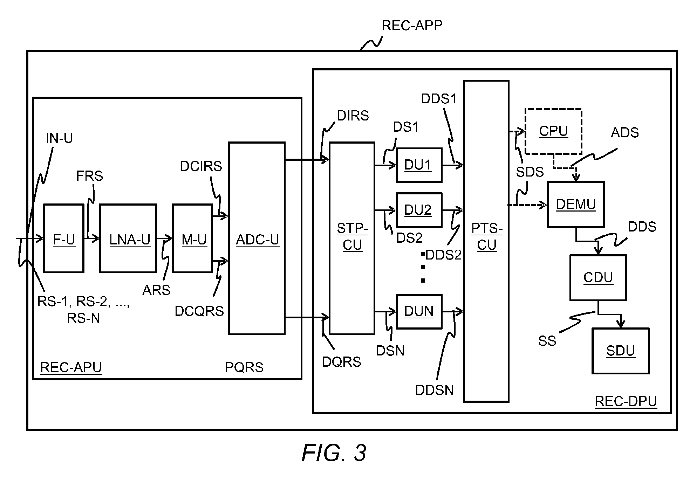

The pre-coding unit PCU pre-codes preferably all data of the first data stream with a first pre-coding weight according to any linear or non-linear pre-coding algorithm, which is known to skilled persons in the art and therefore is not described in further detail. The linear or non-linear pre-coding algorithm may be based on a pre-coding matrix, which is predefined at the transmitter apparatus TRA-APP and at a receiver apparatus REC-APP (see Figure 3). Either an index of the pre-coding matrix may be transmitted from the transmitter apparatus TRA-APP to the receiver apparatus REC-APP or a static and constant pre-coding matrix may be applied for a transmission path between multiple transmit antenna elements being connected to the transmitter apparatus TRA-APP and a receiving antenna system being connected to the receiver apparatus REC-APP.

The pre-coding unit PCU outputs a pre-coded data signal PCDT and passes the pre-coded data signal PCDS to the coding unit CU. In general, the pre-coded data signal PCDS is not orthogonal to a second pre-coded data signal of the second subunit TRA-SUB-2 and to further pre-coded data signals of further subunits up to the *Nth* subunit TRA-SUB-N.

As a main aspect of the present invention, the coding unit CU of the first subunit TRA-SUB-1 encode the first pre-coded data signal PCDS with a first coding and further coding units of the further subunits TRA-SUB-2, ..., TRA-SUB-N encode the second pre-coded data signal and the further pre-coded data signals with further codings preferably by a matrix multiplication with the objective, that data signals generated by the coding unit CU and the further coding units are orthogonal to each other. Therefore, each of the coding unit CU and the further coding units apply one of a set

of orthogonal matrices $\{T_k\}_{k=1}^N$. This means, that the first coding and the further codings are matrix multiplications and that each matrix multiplication applies a matrix with is orthogonal to the matrices of the other matrix multiplications.

The orthogonal matrices $\{T_k\}_{k=1}^N$ may be preferably in addition orthonormal matrices. Such orthogonal matrices $\{T_k\}_{k=1}^N$ may be obtained for example by one of the following mathematical methods: Cholesky decomposition, SVD (SVD = Singular Value Decomposition), Gram-Schmidt process, Housefolder transformation, Givens rotation.

With respect to the so-called Cholesky decomposition the set of orthogonal matrices $\{T_k\}_{k=1}^N$ may be obtained for example by following derivation:

For $k = 1$ to $k = N$ the Cholesky decomposition is applied over $V_k$ with $V_k$ being a generic matrix with a full column rank which means that each of the columns of the matrix is linearly independent. Thereby, following equation needs to be fulfilled:

$$M_k = V_k^H V_k = L_K L_k^H \qquad (1)$$

wherein

$M_k \in \mathbb{C}^{N_{Fk} \, x \, N_{Fk}}$ is a positive-definite Hermitian symmetric matrix,

C : denotes a set of complex numbers,

$N_{Fk}$ : number of transmit antenna elements being connected to k-th subunit TRA-SUB-K of the transmitter apparatus TRA-APP,

$V_k \in \mathbb{C}^{N_{Fk} \, x \, N_{Fk}}$ is an upper triangular matrix,

$V_k^H$ : is the Hermitian transpose of $V_k$,

$L_k \in \mathbb{C}^{N_{Fk} \, x \, N_{Fk}}$ is a lower triangular matrix, which means that the matrix is a square matrix with all entries above the main diagonal being set to zero,

$L_k^H$ : is the Hermitian transpose of $L_k$.

As described above, the detailed described embodiment is given for the case of having equal number $N_F$ of transmit antenna elements: $N_{F1} = N_{F2} = \cdots = N_{FN} = N_F$.

The orthogonal matrices of the set of orthogonal matrices $\{T_k\}_{k=1}^N$ have to fulfil following equation:

$$T_k = V_k (L^{-1})^H \qquad (2)$$

With respect to the so-called SVD the set of orthogonal matrices $\{T_k\}_{k=1}^N$ may be obtained for example by following further derivation:

In a first step, a set of channel matrices $\{\widehat{H}_k\}_{k=1}^N$ may be determined for internal processing paths of the transmitter apparatus TRA-APP preferably from an input of the DPD unit DPDU (see location of coded data signal CDS in Figure 1) to one of the antenna elements and backwards from the one of the antenna elements via an extraction unit EXTU to an output of an analogue-to-digital converter module ADC (see location of digital I and Q feedback signal components FBS3 in Figure 1) as part of an DPD feedback path.

A channel matrix for an overall feedback path of the k-th subunit of the transmitter apparatus TRA-APP may be given by following equation:

$$H_k = \begin{bmatrix} h^k_{11} & h^k_{12} & ... & h^k_{1N_F} \end{bmatrix}$$

wherein:

$h^k_{11}$: channel coefficient, which characterizes a transmitter gain of an internal transmitter path from the input of the DPD unit DPDU to a first transmit antenna of the first set of transmit antennas and backwards from the first transmit antenna of the first set of transmit antennas via the extraction unit EXTU to the output of the analogue-to-digital converter module ADC,

$h^k_{12}$: channel coefficient, which characterizes a transmitter gain of a further internal transmitter path from the input of the DPD unit DPDU to a second transmit antenna of the first set of transmit antennas and backwards from the second transmit antenna of the first set of transmit antennas via the extraction unit EXTU to the output of the analogue-to-digital converter module ADC as part of the DPD feedback path,

$h^1_{1N_F}$: channel coefficient, which characterizes a transmitter gain of an even further internal transmitter path from the input of the DPD unit DPDU to an $N_F$-th transmit antenna of the first set of transmit antennas and backwards from the $N_F$-th transmit antenna of the first set of transmit antennas via the extraction unit EXTU to the output of the analogue-to-digital converter module ADC as part of the DPD feedback path.

The channel matrices may be determined for example during a calibration phase during which known training sequences or reference signals are processed within the transmitter apparatus TRA-APP. Preferably, the coding unit CU should be bypassed or the coding function of the coding unit CU should be switched off, when an estimation of the internal transmitter paths characteristics is done. Since characteristics of the feedback paths may dynamically change with the time (due to environmental conditions, aging process, dynamic effects of analog components, etc) it is also required to recalculate the channel matrices after the calibration phase periodically in a same way by applying the known pilot sequences.

In a second step, a matrix $\tilde{H}_k$ may be determined based on the set of channel matrices $\left\{ \widehat{H}_k \right\}_{k=1}^N$ for example by using following equation:

$$\tilde{H}_k = \begin{bmatrix} \widehat{H}_1^H ... \widehat{H}_{k-1}^H \widehat{H}_{k+1}^H ... \widehat{H}_N^H \end{bmatrix}^H \qquad (3)$$

Equation (3) can be converted into following equation:

$$\tilde{H}_k = \tilde{U}_k \tilde{D}_k \begin{bmatrix} \tilde{V}_k^{(1)} \tilde{V}_k^{(0)} \end{bmatrix}^H \qquad (4)$$

wherein

$\tilde{U}_k \in \mathbb{C}^{N_{Fk} \, x \, rank(\tilde{H}_k)}$: is an unitary matrix whose columns are the eigenvectors to the non-zero eigenvalues of $\tilde{H}_k$,

$\widetilde{D}_k \in \mathbb{R}^{rank(\widetilde{H}_k) \, x \, rank(\widetilde{H}_k)}$: is a diagonal matrix whose entries are the non-negative square roots of the non-zero eigenvalues of $\widetilde{H}_k$,

$\widetilde{V}_k^{(1)} \in \mathbb{C}^{N_{Fk} \, x \, rank(\widetilde{H}_k)}$ consists of the first $rank(\widetilde{H}_k)$ non-zero singular vectors of the non-zero eigenvalues of $\widetilde{H}_k$,

$\widetilde{V}_k^{(0)} \in \mathbb{C}^{N_{Fk} \, x (N_{Fk} - \, rank(\widetilde{H}_k))}$ holds the last $N_{Fk}$ - $rank(\widetilde{H}_k)$ zero singular vectors.

Thus, $\widetilde{V}_k^{(0)}$ forms an orthogonal basis for the null space of the matrix $\widetilde{H}_k$.

From equation (4) each orthogonal matrix $T_k$ of the set of orthogonal matrices $\left\{T_k\right\}_{k=1}^N$ may be determined for example by following equation:

$$T_k = A\widetilde{V}_k^{(0)} \qquad (5)$$

wherein

A: is an arbitrary unitary matrix.

Using one of the above described matrices the coding unit CU generates a coded data stream CDT for example according to following equation:

$$\hat{u}_{fw,k} = T_k u_{fw,k} \qquad (6)$$

wherein

$\hat{u}_{fw,k}$: encoded forward signal (fw = forward) for k-th pre-distortion and amplification unit (here the coded data stream CDT),

$u_{fw,k}$: forward signal of the k-th subunit before encoding by the coding unit CU or one of the further coding units (here the pre-coded data stream PCDT).

The coding unit CU delivers or provides the coded data signal CDS to the first pre-distortion and amplification unit TRA-APU-1 of the first subunit TRA-SUB-1.

The first pre-distortion and amplification unit TRA-APU-1 contains following components, units or modules: the DPD unit DPDU, a digital-to-analogue converter module DAC, one or several first processing units PU1 such as mixers, a combiner, and an optional attenuator, a power amplifier unit PAU, a filter unit FU1, an extraction unit EXTU such as a directional coupler, one or several second processing units PU2 such as a further attenuator, a further filter unit, a splitter, and further mixers, the analogue-to-digital converter module ADC and a DPD adaptation unit ADAPU.

The DPD unit DPDU performs a digital pre-distortion of the coded data signal CDS by calculating in a first step an error signal $e_k$ for the k-th pre-distortion and amplification unit for example by using following equation:

$$e_k = \hat{u}_{fw,k} - \hat{y}_{fb,k} \qquad (7)$$

wherein

$\hat{y}_{fb,k}$: feedback signal FBS4 (fb = feedback) of the k-th pre-distortion and amplification unit provided from the DPD adaptation unit ADAPU.

From the error signal $e_k$ DPD coefficients $w_k$ are calculated by following equation (8) according to a functional relationship $f(e_k)$ of any pre-distortion technique, which is known to skilled persons in the art and therefore is not described in further detail for simplification.

$$w_k = f(e_k) \qquad (8)$$

The DPD unit DPDU applies the DPD coefficients $w_k$ for generating a pre-distorted data signal PDS with digital I and Q components (I = in-phase, Q = quadrature), which are further provided to the first digital-to-analogue converter module DAC-1. The digital I and Q components are converted into analogue I and Q signal components ASC by separate digital-to-analogue converters of the first digital-to-analogue converter module DAC-1.
The analogue I and Q signal components ASC are further provided to the first processing unit PU1. A first mixer of the first processing unit PU1 up-converts the analogue I signal component to a desired frequency range such as an LTE OFDM subcarrier (LTE = Long Term Evolution) and a second mixer of the first processing unit PU1 up-converts the analogue Q signal component to the desired frequency range. The up-converted analogue I and Q signal components are superimposed to a sum signal by the combiner and the sum signal is provided to the optional attenuator, which may be considered as an analogue power control for conditioning the sum signal to an input characteristic of the power amplifier unit PAU.
The first processing unit PU1 outputs a conditioned analogue data signal CADS and provides the conditioned analogue data signal CADS to the power amplifier unit PAU. The power amplifier unit PAU amplifies the conditioned analogue data signal CADS to an amplified data signal ADS with a predefined power level, which may be adapted in such a way that the transmit signals TS-1, TS-2, ..., TS-N can be received at the one or several receiver apparatuses REC-APP and the data streams can be recovered at the one or several receiver apparatuses REC-APP.
The amplified data signal ADS may be further provided to the filter unit FU1, which may be any commonly used filter such as a duplex filter for isolation between the first subunit TRA-SUB-1 of the transmitter apparatus TRA-APP and a co-located receiver apparatus, when both the first subunit TRA-SUB-1 and the co-located receiver apparatus are connected to the same antenna element or the same set of antenna elements. The filter unit FU1 outputs a filtered amplified data signal FADS.
A predefined ratio or fraction of the filtered amplified data signal FADS is extracted by the extraction unit EXTU to a feedback path as a feedback signal FBS1 of the first pre-distortion and amplification unit TRA-APU-1 as done in any conventional transmitter apparatus. A larger remaining part of the filtered amplified data signal FADS is provided to a first output unit OU-1 of the transmitter apparatus TRA-APP. In a same way, the further subunits TRA-SUB-2, ..., TRA-SUB-N provide filtered amplified data signals to further output units OU-2, ..., OU-N of the transmitter apparatus TRA-APP. The first output unit OU-1 and the further output units OU-2, ..., OU-N may be for example coaxial connectors for one or several feeder cables, which conduct the first transmit signal TS-1 to the first transmit antenna element and the further transmit signals TS-2, ..., TS-N to the further transmit antenna elements.
The feedback signal FBS1 is provided to the second processing unit PU2. The filter of the second processing unit PU2 may be an analogue pass band filter, which passes signal frequencies belonging to a supported/desired frequency range and which rejects signal frequencies outside the supported/desired frequency range. The filtered feedback signal is provided to the attenuator of the second processing unit PU2, which attenuates the filtered feedback signal by an attenuation level, which may have preferably an inverse value of an amplification gain of the power amplifier unit PAU. The attenuated feedback signal is separated into I and Q feedback signal components by the splitter of the second processing unit PU2. The I feedback signal component is down-converted by a first mixer of the second processing unit PU2 preferably to a baseband frequency of 0 Hz and the Q feedback signal component is down-converted by a second mixer of the second processing unit PU2 also to the baseband frequency of 0 Hz.
The down-converted I and Q feedback signal components FBS2 are provided from the second processing unit PU2 to the analogue-to-digital converter module ADC. A first analogue-to-digital converter of the analogue-to-digital converter module ADC converts the down-converted I feedback signal component into a digital I feedback signal component and a second analogue-to-digital converter of the analogue-to-digital converter module ADC converts the down-converted Q feedback signal component into a digital Q feedback signal component.
The digital I and Q feedback signal components FBS3 are provided from the analogue-to-digital converter module ADC to the DPD adaptation unit ADAPU. The DPD adaptation unit ADAPU multiplies the digital I and Q feedback signal components FBS3 with a same matrix $T_k$ as applied by the coding unit CU for suppressing signal parts of a coupling of feedback signals from neighbouring subunits of the first subunit TRA-SUB-1 to the feedback signal FBS1 by using for example following equation:

$$\hat{y}_{fb,k} = T_k \tilde{y}_{fb,k} \qquad (9)$$

wherein

$\tilde{y}_{fb,k}$: the digital I and Q feedback signal components FBS3 before matrix multiplication.

The term $\tilde{y}_{fb,k}$ may be represented by following equation:

$$\tilde{y}_{fb,k} = T_k y_{fb,k} + \sum_{\substack{j=1 \\ j \neq k}}^{N} T_j y_{fb,j} \qquad (10)$$

wherein

$y_{fb,k}$: desired feedback signal of the k-th pre-distortion and amplification unit without coupling of feedback signals from the other N-1 feedback paths.

When substituting $\tilde{y}_{fb,k}$ in equation (9) with the definition of equation (10) following equation is obtained:

$$\hat{y}_{fb,k} = T_k T_k y_{fb,k} + \sum_{\substack{j=1 \\ j \neq k}}^{N} T_k T_j y_{fb,j} \qquad (11)$$

$T_k$ is orthogonal to $T_j$ with $\forall k \neq j$ due to the orthogonal matrices, which are obtained by one of the mathematical methods as described above. Thus, for the second summand in equation (11) following approximation can be assumed:

$$\sum_{\substack{j=1 \\ j \neq k}}^{N} T_k T_j y_{fb,j} \approx 0 \qquad (12)$$

Then, equation (11) can be simplified to following equation:

$$\hat{y}_{bf,k} \approx T_k T_k y_{fb,k} = \|T_k\|^2 y_{fb,k} \qquad (13)$$

When the matrices are preferably orthonormal, equation (13) can be further simplified to:

$$\hat{y}_{fb,k} \approx y_{fb,k} \qquad (14)$$

This means, that the feedback signal FBS4 (fb = feedback) of the k-th pre-distortion and amplification unit does not contain any noise components coupled from the neighbouring feedback paths of the other N-1 pre-distortion and amplification units because these noise components are eliminated by the processing and matrix multiplication of the DPD adaptation unit ADAPU. The DPD adaptation unit ADAPU provides the result of equation (14) as the feedback signal FBS4 to the DPD unit DPDU.

In an alternative embodiment multiplication of the DPD coefficients $w_k$ by the coded data signal CDS may be executed by the DPD adaptation unit ADAPU. In such a case, the coded data signal CDS may be provided as a DPD signal DPD-S to the DPD adaptation unit ADAPU, which perform the multiplication and provides a results of the multiplication as the feedback signal FBS4 to the DPD unit DPDU.

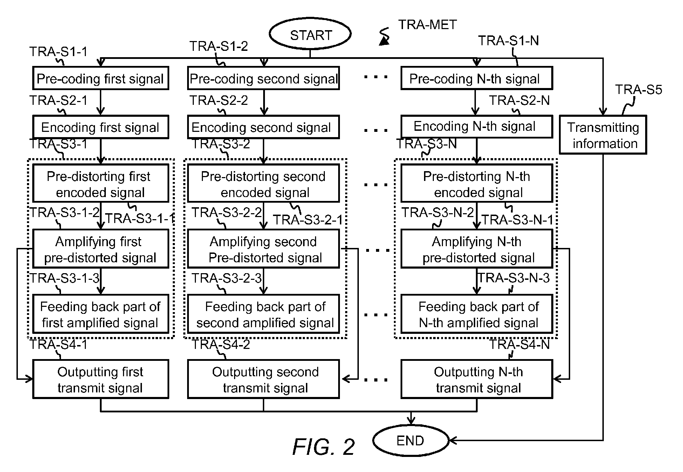

Figure 2 shows a flow diagram of a transmitter method TRA-MET for transmitting the transmit signals TS-1, TS-2, ..., TS-N from multiple antenna elements. The number of the steps for performing the method TRA-MET is not critical, and as can be understood by those skilled in the art that the number of the steps and the sequence of the steps may vary without departing from the scope of the embodiments of the invention as defined in the appended claims.

When multi-stream beamforming is applied, in a first one TRA-S1-1 of optional steps TRA-S1-1, TRA-S1-2, ..., TRA-S1-N the first data signal DS is pre-coded and by further optional steps TRA-S1-2, ..., TRA-S1-N a second data signal and further data signals up to the N-th data signal are pre-coded by any conventional pre-coding method known to skilled persons in the art and preferably the steps TRA-S1-1, TRA-S1-2, ..., TRA-S1-N are executed simultaneously and in parallel.

In a first one TRA-S2-1 of next steps TRA-S2-1, TRA-S2-2, ..., TRA-S2-N the pre-coded data signal PCDS is encoded by the first coding and by further steps TRA-S2-2, ..., TRA-S2-N further pre-coded data signals are encoded by further codings as described above with respect to Figure 1 and preferably the steps TRA-S2-1, TRA-S2-2, ..., TRA-S2-N are executed simultaneously and in parallel.

In a first one TRA-S3-1 of further steps TRA-S3-1, TRA-S3-2, ..., TRA-S3-N the encoded signal CDS is processed by the first pre-distortion and amplification unit TRA-APU-1 and by further steps TRA-S3-2, ..., TRA-S3-N further encoded signals are processes by the further pre-distortion and amplification units TRA-APU-2, ..., TRA-APU-N and preferably the steps TRA-S3-1, TRA-S3-2, ..., TRA-S3-N are executed simultaneously and in parallel.

The step TRA-S3-1 contains a first sub-step TRA-S3-1-1 for pre-distorting the encoded signal CDS, a second sub-step TRA-S3-1-2 for amplifying the pre-distorted signal CADS and a third sub-step TRA-S3-1-3 for feeding back a part or fraction of the filtered and amplified data signal FADS. In a same way, the step TRA-S3-2 contains a first sub-step TRA-S3-2-1 for pre-distorting a further encoded signal, a second sub-step TRA-S3-2-2 for amplifying a further pre-distorted signal and a third sub-step TRA-S3-2-3 for feeding back a part or fraction of a further filtered and amplified data signal. Equally, the step TRA-S3-N contains a first sub-step TRA-S3-N-1 for pre-distorting an N-th encoded signal, a second sub-step TRA-S3-N-2 for amplifying an N-th pre-distorted signal and a third sub-step TRA-S3-N-3 for feeding back a part or fraction of an N-th filtered and amplified data signal.

In a first one TRA-S4-1 of next steps TRA-S4-1, TRA-S4-2, ..., TRA-S4-N the filtered and amplified data signal FADS is output as the transmit signal TS-1 from the transmitter apparatus TRA-APP and by further steps TRA-S4-2, ..., TRA-S4-N the further filtered and amplified data signals are output as the transmit signals TS-2, ..., TS-N from the transmitter apparatus TRA-APP and preferably the steps TRA-S4-1, TRA-S4-2, ..., TRA-S4-N are executed simultaneously and in parallel.

By an optional step TRA-S5 information of the first coding and the at least second coding such as indexes of the matrices are transmitted from the transmitter apparatus TRA-APP to the receiver apparatus REC-APP, when the data streams being processed by the subunits TRA-SUB-1, TRA-SUB-2, ..., TRA-SUB-N are dedicated for the receiver apparatus REC-APP as a single receiver. Alternatively with respect to multiuser MIMO, during the step TRA-S5 information of the first coding may be transmitted from the transmitter apparatus TRA-APP to a first receiver apparatus of the first transmit signal TS-1 and at least further information of the at least second coding may be transmitted from the transmitter apparatus TRA-APP to at least one second receiver apparatus of the at least second transmit signal TS-2, ..., TS-N. The step TRA-S5 may be executed at a beginning of a transmission from the transmitter apparatus TRA-APP to the receiver apparatus REC-APP or in between when at least one of the applied codings will be changed during the transmission.

Figure 3 shows schematically a block diagram of the receiver apparatus REC-APP according to an exemplarily embodiment for receiving and processing radio frequency signals, which have been transmitted from the transmitter apparatus TRA-APP via multiple antenna elements. A splitting of processing functions across processing units shown in Figure 3 is not critical, and as can be understood by those skilled in the art that the number of processing units, the number of processing functions and an allocation of the processing functions to the processing units may vary without departing from the scope of the embodiments of the invention as defined in the appended claims.

The exemplarily shown receiver apparatus REC-APP contains an input unit IN-U such as a coaxial connector for receiving a first receive signal RS-1 and further receive signals RS-2, ..., RS-N being superimposed from a receiving antenna system which is connected to the receiver apparatus REC-APP. The receiving antenna system may contain a single antenna element or several antenna elements such as 2, 4, 8 or even more antenna elements. For simplification only a single antenna element may be connected to the receiver apparatus REC-APP as shown in Figure 3. A skilled person in the art may easily adapt the receiver apparatus REC-APP to a receiver apparatus, which is connected to a receiving antenna system with multi receive antenna elements.

The first receive signal RS-1 may correspond to the first transmit signal TS-1 but changed by a propagation from the first set of transmit antenna elements to the receiving antenna system and in a same way the further receive signals RS-2, ..., RS-N may correspond to the further transmit signals TS-2, ..., TS-N but also changed by a propagation from the further sets of transmit antenna elements to the receiving antenna system.

The receiver apparatus REC-APP further contains an analogue processing subunit REC-APU also referred to as receiver RF domain and a digital processing subunit REC-DPU also referred to as receiver DSP domain.

The analogue processing subunit REC-APU contains a filter unit F-U such as any analogue band-select filter known to skilled persons in the art, an amplification unit LNA-U such as any low noise amplifier known to skilled persons in the art, a mixer unit M-U and an analogue-to-digital converter unit DAC-U. The filter unit F-U filters the receive signals RS-1, RS-2, ..., RS-N in such a way, that noise of a frequency band, which is received and processed by the receiver apparatus REC-APP is below a predefined maximum noise level and the predefined maximum noise level may depend on a sensitivity (e.g. minimum input power detectable by the receiver apparatus REC-APP) of components of the receiver apparatus REC-APP.

The filter unit F-U generates a filtered receive signal FRS, which contains the superimposed and filtered receive signals RS-1, RS-2, ..., RS-N. The filtered receive signal FRS is further provided to the amplification unit LNA-U, which amplifies the filtered receive signal FRS to a power level, which is suitable for further processing. Details for operating such an amplification unit are well known to skilled persons in the art and therefore are not described in further detail for simplification.

The amplification unit LNA-U generates an amplified receive signal ARS and provides the amplified receive signal ARS to the mixer unit M-U. The mixer unit M-U contains a splitter for splitting the amplified receive signal ARS into I and Q components. The mixer unit M-U further contains a first mixer for down-converting the I component of the amplified receive signal ARS to a down-converted I component signal DCIRS and contains a second mixer for down-converting the Q component of the amplified receive signal ARS to a down-converted Q component signal DCQRS by any down-converting procedure known to skilled persons in the art.

The mixer unit M-U provides the down-converted I component signal DCIRS and the down-converted Q component signal DCQRS to the analogue-to-digital converter unit ADC-U. The analogue-to-digital converter unit ADC-U converts the down-converted I component signal DCIRS by a first analogue-to-digital converter to a digital I component signal DIRS and converts the down-converted Q component signal DCQRS by a second analogue-to-digital converter to a digital Q component signal DQRS.

The analogue-to-digital converter unit ADC-U provides the digital I component signal DIRS and the digital Q component signal DQRS as input parameters to the digital processing subunit REC-DPU.

The digital processing subunit REC-DPU such as a DSP or an FPGA exemplarily contains following components: a serial-to-parallel converter unit STP-CU, a first decoding unit DU1, a number of $N$ - 1 further decoding units DU2, ..., DUN, a parallel-to-serial converter unit PTS-CU, an optional compensating unit CPU, a demodulation unit DEMU, a channel decoder unit CDU and a symbol detection unit SDU.

The serial-to-parallel converter unit STP-CU receives the digital I component signal DIRS and the digital Q component signal DQRS as input parameters from the analogue processing subunit REC-APU. The digital I component signal DIRS is a superposition of digital I components of the receive signals RS-1, RS-2, ..., RS-N and the digital Q component signal DQRS is a further superposition of digital Q components of the receive signals RS-1, RS-2, ..., RS-N.

By a processing of the serial-to-parallel converter unit STP-CU known to skilled persons in the art, the digital I component of the first receive signal RS-1 is extracted from the digital I component signal DIRS and the digital Q component of the first receive signal RS-1 is also extracted from the digital Q component signal DQRS. Furthermore, by the processing of the serial-to-parallel converter unit STP-CU, the digital I component and the digital Q component of the first receive signal RS-1 are combined to a first digital signal DS1 and are provided to the first decoding unit DU1. In a same way by the processing of the serial-to-parallel converter unit STP-CU, further digital I components of the further receive signal RS-2, ..., RS-N are extracted from the digital I component signal DIRS and further digital Q components of the further receive signals RS-2, ..., RS-N are extracted from the digital Q component signal DQRS. Also in a same way, by the processing of the serial-to-parallel converter unit STP-CU, in each case one of the further digital I components and a corresponding one of the further digital Q components are combined to one of further digital signals DS2, ..., DSN, which are provided to the further decoding units DU2, ..., DUN.

Two operation modes for the first decoding unit DU1 and the further decoding units DU2, ..., DUN can be distinguished and may be applied as alternative embodiments. In a first operation mode, a matrix $T_{encoder,k}$ which is applied by one of the coding unit CU and the further coding units of the transmitter apparatus TRA-APP may be orthonormal to a matrix $T_{decoder,k}$ which is applied by a corresponding one of the decoding units DU1, DU2, ..., DUN. In this case, the one of the coding unit CU and the further coding units and the corresponding one of the decoding units DU1, DU2, ..., DUN may apply a same matrix, which means $T_{encoder,k} = T_{decoder,k} = T_k$. The corresponding one of the decoding units DU1, DU2, ..., DUN may execute in this case a mathematical operation for example according to following equation:

$$\hat{y}_{RS,k} \approx T_{decoder,k}T_{encoder,k} \cdot y_{RS,k} = \|T_k\|^2 y_{RS,k} = y_{RS,k} \tag{15}$$

wherein *RS, k (k = 1...N)* denotes one of the received signal RS-1, RS-2, ..., RS-N at the receiver apparatus REC-APP (see Figure 3).

In a second operation mode, the matrix $T_{encoder,k}$ which is applied by the one of the coding unit CU and the further coding units of the transmitter apparatus TRA-APP may be orthogonal but non-orthonormal to the matrix $T_{decoder,k}$ which is applied by the corresponding one of the decoding units DU1, DU2, ..., DUN. With respect to the second operation mode, the decoding units DU1, DU2, ..., DUN may be operated according to a first option with a matrix $T_{decoder,k}$, which is an inverse matrix of the matrix $T_{encoder,k}$ according to following equation:

$$T_{decoder,k} = \left(T_{encoder,k}\right)^{-1} \tag{16}$$

The corresponding one of the decoding units DU1, DU2, ..., DUN may execute with respect to the first option a mathematical operation for example according to following equation:

$$\hat{y}_{RS,k} \approx T_{decoder,k}T_{encoder,k} \cdot y_{RS,k} = \left(T_{encoder,k}\right)^{-1}T_{encoder,k} \cdot y_{RS,k} = y_{RS,k} \tag{17}$$

Alternatively according to a second option, the one of the coding unit CU and the further coding units and the corresponding one of the decoding units DU1, DU2, ..., DUN may apply a same matrix, which means $T_{encoder,k} = T_{decoder,k} = T_k$. The corresponding one of the decoding units DU1, DU2, ..., DUN may execute with respect to the second option a mathematical operation for example according to following equation:

$$\hat{y}_{RS,k} \approx T_{decoder,k}T_{encoder,k} \cdot y_{RS,k} = \|T_k\|^2 y_{RS,k} \tag{18}$$

Thereby, the term $\|T_k\|^2$ represents a so-called processing gain which is a linear term and which fulfills following characteristic: $\|T_k\|^2 > 1$. The processing gain may be taken into account within the further processing chain by applying for example the compensating unit CPU.

Despite the appearing processing gain, the second option may be preferably applied, when the matrices of the coding units and the corresponding decoding units are non-orthonormal, because the second option has a lower mathematical complexity than the first option and because software code from the first operation mode may be reused.

The first decoding unit DU1 generates a decoded digital signal DDS1 and the further decoding units DU2, ..., DUN generate corresponding further decoded digital signals DDS2, ..., DDSN. The decoded digital signal DDS1 and the further decoded digital signals DDS2, ..., DDSN are provided to the parallel-to-serial converter unit PTS-CU, which generates a serial digital signal SDS according to any parallel-to-serial processing procedure, which is known to skilled persons in the art.

When the second option of the second operation mode is applied, the serial digital signal SDS may be provided to the compensating unit CPU, which compensates the processing gain for example by any digital leveller or any digital attenuator which is known to skilled persons in the art. The compensating unit CPU generates an attenuated digital signal ADS which may be provided to the demodulation unit DEMU such as an LTE OFDM demodulator known to skilled persons in the art. When either the first operation mode or the first option of the second operation mode is applied, the serial digital signal SDS may be directly provided to the demodulation unit DEMU.

The demodulation unit DEMU generates a demodulated digital signal DDS which is provided to the channel decoder unit CDU. The channel decoder unit CDU may be for example a so-called Turbo decoder based on a so-called MAP algorithm (MAP = Maximum a Posteriori) or a so-called Log-MAP algorithm, which has lower complexity than the MAP algorithm. Alternatively the channel decoder unit CDU may be a so-called Viterbi decoder etc. Usually by a transmitter such as the transmitter apparatus TRA-APP a sequence of bits is encoded with an error correction coding by using for example a so-called Reed Solomon encoder. Thereby, redundancy is added to the sequence of bits so that if an error occurs during the wireless transmission for example due to noise, the error can be corrected at the receiver apparatus REC-APP. The channel decoder unit CDU generates a symbol stream SS such as an OFDM symbol stream, which is applied to the symbol detection unit SDU. The symbol detection unit SDU tries to detect correctly each symbol of the symbol stream SS for recovering the data, which are transmitted by the first transmit antenna element and the further transmit antenna elements.

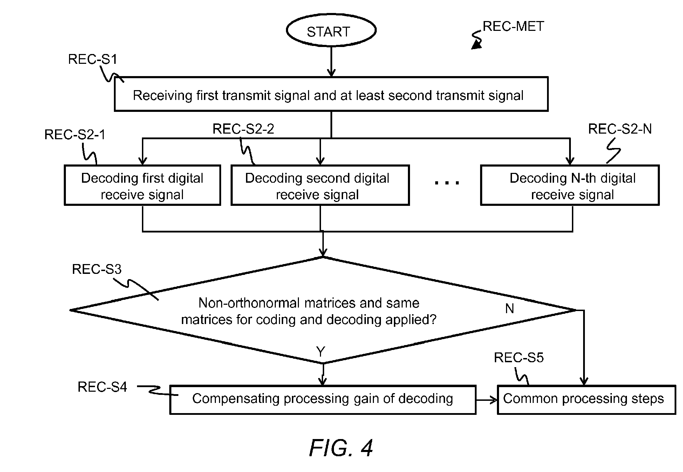

Figure 4 shows schematically a flow diagram of a receiver method REC-MET according to an exemplary embodiment for receiving and processing radio frequency signals, which are transmitted from multiple antenna elements being connected to the transmitter apparatus TRA-APP. The number of the steps for performing the method REC-MET is not critical, and as can be understood by those skilled in the art that the number of the steps and the sequence of the steps may vary without departing from the scope of the embodiments of the invention as defined in the appended claims.

In a first step REC-S1, the first transmit signal TS-1 is received as a first received signal RS-1 and the further transmit signals TS-2, ..., TS-N are received as further received signals RS-2, ..., RS-N.

In a first one REC-S2-1 of next steps REC-S2-1, REC-S2-2, ..., REC-S2-N preferably at a beginning of a digital processing chain, which is for example the digital processing subunit REC-DPU, the first digital signal DS1 is decoded as described above with respect to Figure 3. In a similar way, by further steps REC-S2-2, ..., REC-S2-N also preferably at the beginning of the digital processing chain, the further digital signals DS2, ..., DSN are decoded as described above with respect to Figure 3. Preferably the steps REC-S2-1, REC-S2-2, ..., REC-S2-N are executed simultaneously and in parallel.

In a next step REC-S3 the receiver method REC-MET may verify, whether non-orthonormal matrices and same matrices may be applied for coding and decoding according to the second option of the second operation mode as described above. When orthonormal matrices are applied or when not the same matrices according to the second option of the second operation mode are applied, the receiver method REC-MET will be continued with step REC-S5, which may contain a set of common receiver substeps such as demodulation, channel decoding and symbol detection. When else non-orthonormal matrices and same matrices may be applied for coding and decoding according to the second option of the second operation mode, step REC-S4 may be a next step.

Using the step REC-S4, the processing gain which is generated by using the second option of the second operation mode is compensated as described above with respect to Figure 3. The next step after the step REC-S4 may be the step REC-S5.

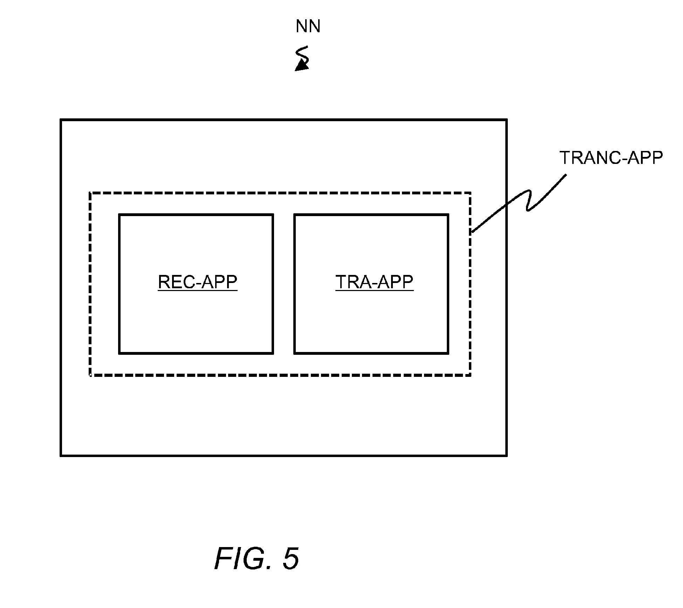

Figure 5 shows schematically a block diagram of a network node NN according to an exemplarily embodiment. The network node NN contains the transmitter apparatus TRA-APP and/or the receiver apparatus REC-APP. The transmitter apparatus TRA-APP and the receiver apparatus REC-APP may be components of a transceiver apparatus TRANC-APP. The network node NN may be for example a base station, a relay, a repeater or a mobile station.

The term "base station" may be considered synonymous to and/or referred to as a base transceiver station, access point base station, access point, macro base station, macrocell, micro base station, microcell, femtocell, picocell etc. and may describe equipment that provides wireless connectivity via one or more radio links to one or more mobile stations. The base station BS1-1 may be for example an LTE Node B, an IEEE 802.11 access point, a WiMAX base station etc.

The term "repeater" may be considered synonymous to and/or referred to as an electronic device that receives a signal and simply retransmits it at a higher level or higher power, or onto another side of an obstruction, so that the signal can cover longer distances.

The term "relay" may be considered synonymous to and/or referred to as an electronic radio communication device that receives a signal and retransmits a different signal not only at a higher level or higher power, but also at a different frequency and/or different time slot and/or spreading code, to increase capacity in a wireless access network and to improve wireless link performance.

The term "mobile station" may be considered synonymous to, and may hereafter be occasionally referred to, as a mobile unit, mobile user, access terminal, user equipment, subscriber, user, remote station or a small cell, pico cell or femto cell when located in a moving vehicle such as a bus, a train or even a car. Each of the mobile stations UE1, UE2 may be for example a cellular telephone, a smart phone, a portable computer, a pocket computer, a hand-held computer, a personal digital assistant, a moving base station, a smart watch, a head mounted display such as a Google glass or a car-mounted mobile device such as a repeater or relay.

The term "macro base station" may be considered synonymous to and/or referred to a base station, which provides a radio cell having a size in a range of several hundred meters up to several kilometres. A macro base station usually has a maximum output power of typically tens of watts.

The term "micro base station" may be considered synonymous to and/or referred to a base station, which provides a radio cell having a size in a range of several tens of meters up to hundred meters. A micro base station usually has a maximum output power of typically several watts.

The term "macro cell" may be considered synonymous to and/or referred to a radio cell, which provides the widest range of all radio cell sizes. Macro cells are usually found in rural areas or along highways.

The term "micro cell" may be considered synonymous to and/or referred to a radio cell in a cellular network served by a low power cellular base station, covering a limited area (smaller than an area of a macro cell) such as a mall, a hotel, or a transportation hub. A microcell is referred to a group of radio cells, which contain pico cells and femto cells.

The term "pico cell" may be considered synonymous to and/or referred to a small cellular base station typically covering a small area, such as in-building (offices, shopping malls, train stations, stock exchanges, etc.), or more recently in-aircraft. In cellular networks, pico cells are typically used to extend coverage to indoor areas where outdoor signals do not reach well, or to add network capacity in areas with very dense phone usage, such as train stations.

The term "femto cell" may be considered synonymous to and/or referred to a small, low-power cellular base station, typically designed for use in a home or small business. A broader term which is more widespread in the industry is small cell, with femto cell as a subset.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for transmitting", "means for receiving", "means for determining" etc. (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, DSP hardware, network processor, ASIC, FPGA, read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown. Furthermore, the following claims are hereby incorporated into the detailed description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that the transmitter method TRA-MET and the receiver method REC-MET disclosed in the specification or in the claims may be implemented by a device having means for performing each of the respective steps of these methods. Preferably, a computer program product may contain computer-executable instructions for performing the transmitter method TRA-MET or the receiver method REC-MET, when the computer program product is executed on a programmable hardware device such as a DSP, an ASIC or an FPGA. Preferably, a digital data storage device may encode a machine-executable program of instructions to perform one of the transmitter method TRA-MET and the receiver method REC-MET.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1.  A transmitter method (TRA-MET) for transmitting radio frequency signals from multiple antenna elements comprising:

    - encoding (TRA-S2-1) a first signal (PCDS) with a first coding before being processed by a first pre-distortion and amplification unit (TRA-APU-1),
    - at least one second encoding (TRA-S2-2, ..., TRA-S2-N) of at least one second signal with at least one second coding before being processed by at least one second pre-distortion and amplification unit (TRA-APU-2, ..., TRA-APU-N),
    - processing (TRA-S3-1) said first encoded signal (CDS) by said first pre-distortion and amplification unit (TRA-APU-1) for obtaining a first amplified pre-distorted encoded signal (ADS),
    - processing (TRA-S3-2, ..., TRA-S3-N) said at least second encoded signal by said at least second pre-distortion and amplification unit (TRA-APU-2, ..., TRA-APU-N) for obtaining at least one second amplified pre-distorted encoded signal, and
    - outputting (TRA-S4-1) said first amplified pre-distorted encoded signal as a first transmit signal (TS-1) to a first transmit antenna element, and
    - outputting (TRA-S4-2, ..., TRA-S4-N) said at least one second amplified pre-distorted encoded signal as at least one second transmit signal (TS-2, ..., TS-N) to at least one second transmit antenna element.

2.  Transmitter method (TRA-MET) according to claim 1, wherein said transmitter method (TRA-MET) further comprises:

    - pre-coding (TRA-S1-1) a first data signal (DS) for obtaining a pre-coded data signal (PCDS) and wherein said encoding (TRA-S2-1) encodes said pre-coded data signal (PCDS), and
    - pre-coding (TRA-S1-2, ..., TRA-S1-N) at least one second data signal for obtaining at least one second pre-coded data signal and wherein said at least one second encoding (TRA-S2-2, ..., TRA-S2-N) encodes said at least one second pre-coded data signal.

3.  Transmitter method (TRA-MET) according to any of the preceding claims, wherein said first coding and said at least one second coding are orthogonal codes.

4.  Transmitter method (TRA-MET) according to claim 3, wherein said orthogonal codes are determined by either of the following:

    - Cholesky decomposition,
    - singular value decomposition,
    - Gram-Schmidt process,
    - Housefolder transformation,
    - Givens rotation.

5.  Transmitter method (TRA-MET) according to claim 3 or claim 4, wherein said orthogonal codes are othonormal matrices.

6.  Transmitter method (TRA-MET) according to any of the preceding claims, wherein said encoding (TRA-S1-1) of said first signal (PCDS) encodes all data to be transmitted by said first transmit antenna element and wherein said encoding (TRA-S1-2, ..., TRA-S1-N) of said at least one second signal encodes all data to be transmitted by said at least one second antenna element.

7.  Transmitter method (TRA-MET) according to any of the preceding claims, wherein said transmitter method (TRA-MET) further comprises transmitting (TRA-S6) information of said first coding and of said at least one second coding to a single receiver apparatus (REC-APP) of said first transmit signal (TS-1) and of said at least second antenna signal (TS-2, ..., TS-N) or further comprises transmitting (TRA-S6) first information of said first coding to a first receiver apparatus (REC-APP) of said first transmit signal (TS-1) and at least second information of said at least second coding to at least one second receiver apparatus (REC-APP) of said at least one second transmit signal (TS-2, ..., TS-N).

8.  Transmitter method (TRA-MET) according to any of the preceding claims 1 to 6, wherein said first coding and said at least one second coding are predefined at a transmitter apparatus (TRA-APP) executing said transmitter method (TRA-MET) and at at least one receiver apparatus (REC-APP) receiving at least one of said first transmit signal (TS-1) and said at least one second transmit signal (TS-2, ..., TS-N).

9. A receiver method (REC-MET) for radio frequency signals being transmitted from multiple antenna elements comprising:

- receiving (REC-S1) a first transmit signal (TS-1) being encoded by a first coding for a first pre-distortion and amplification unit (TRA-APU-1) and being transmitted by a first transmit antenna element as a first received signal (RS-1) and at least one second transmit signal (TS-2, ..., TS-N) being encoded by at least one second coding for at least one second pre-distortion and amplification unit (TRA-APU-2, ..., TRA-APU-N) and being transmitted by at least one second transmit antenna element as at least one second received signal (RS-2, ..., RS-N),
- a first decoding (REC-S2-1) of said first received signal (RS-1) for reversing said first coding, and
- at least one second decoding (REC-S2-2, ..., REC-S2-N) of said at least second received signal (RS-2, ..., RS-N) for reversing said at least one second coding.

10. Receiver method (REC-MET) according to claim 9, wherein, when a first decoding matrix is applied for said first decoding (REC-S2-1) and is orthonormal to at least one second decoding matrix being appliedfor said at least one second decoding (REC-S2-2, ..., REC-S2-N) and when a first coding matrix is applied by a transmitter method (TRA-MET) for coding said first transmit signal (TS-1) and is orthonormal to at least one second coding matrix being applied by said transmitter method (TRA-MET) for coding said at least one second transmit signal (TS-2, ..., TS-N), said first decoding matrix is equal to said first coding matrix and said at least one second decoding matrix is equal to said at least one second coding matrix.

11. Receiver method (REC-MET) according to claim 9, wherein, when a first decoding matrix is applied for said first decoding (REC-23-1) and is non-orthonormal to at least one second decoding matrix being applied for said at least one second decoding (REC-S2-2, ..., REC-S2-N) and when a first coding matrix is applied by a transmitter method (TRA-MET) for coding said first transmit signal (TS-1) and is non-orthonormal to at least one second coding matrix being applied by said transmitter method (TRA-MET) for coding said at least one second transmit signal (TS-2, ..., TS-N), either said first decoding matrix is inverse to said first coding matrix and said at least one second decoding matrix is inverse to said at least one second coding matrix or said first decoding matrix is equal to said first coding matrix, said at least one second decoding matrix is equal to said at least one second coding matrix and said receiver method (REC-MET) further comprises compensating (REC-S4) a processing gain of said at least one of said first decoding (REC-S2-1) and of said at least second decoding (REC-S2-2, ..., REC-S2-N).

12. Receiver method (REC-MET) according to any of the preceding claims 9 to 11, wherein said first decoding (REC-S2-1) and said at least one second decoding (REC-S2-2, ..., REC-S2-N) are executed at a beginning of a digital processing chain (REC-DPU).

13. A transmitter apparatus (TRA-APP) for transmitting radio frequency signals from multiple antenna elements comprising:

- means (CU-1) for encoding with a first coding a first signal (PCDT-1) before being processed by a first pre-distortion and amplification unit (TRA-APU-1),
- means for encoding with at least one second coding at least one second signal before being processed by at least one second pre-distortion and amplification unit (TRA-APU-2, ..., TRA-APU-N),
- said first pre-distortion and amplification unit (TRA-APU-1) for processing said first encoded signal (CDT-1) and for obtaining a first amplified pre-distorted encoded signal,
- said at least one second pre-distortion and amplification unit (TRA-APU-2, ..., TRA-APU-N) for processing said at least second encoded signal and for obtaining at least one second amplified pre-distorted encoded signal, and
- means (OU-1) for outputting said first amplified pre-distorted encoded signal as a first transmit signal (TS-1) to a first transmit antenna element, and
- means (OU-2, ..., OU-N) for outputting said at least one second amplified pre-distorted encoded signal as at least one second transmit signal (TS-2, ..., TS-N) to at least one second transmit antenna element.

14. A receiver apparatus (REC-APP) for radio frequency signals being transmitted from multiple antenna elements comprising:

- means (IN-U) for receiving as a first received signal (RS-1) a first transmit signal (TS-1) being encoded by a first coding for a first pre-distortion and amplification unit (TRA-APU-1) and being transmitted from a first transmit antenna element as a first received signal (RS-1) and for receiving as at least one second received signal (RS-2, ..., RS-N) at least one second transmit signal (TS2, ..., TS-N) being encoded by at least one second coding for at least one second pre-distortion and amplification unit (TRA-APU-2, ..., TRA-APU-N) and being transmitted from at least one second transmit antenna element,
- means (DU1) for a first decoding of said first received transmit signal (DS1) for reversing said first coding, and
- means (DU2, ..., DUN) for at least one second decoding of said at least second received transmit signal (DS2, ..., DSN) for reversing said at least one second coding.

15. A network node (NN) comprising a transmitter apparatus (TRA-APP) according to claim 13 and/or a receiver apparatus (REC-APP) according to claim 14.

**Amended claims in accordance with Rule 137(2) EPC.**

1. A transmitter method (TRA-MET) for transmitting radio frequency signals from a transmitter apparatus (TRA-APP) via multiple antenna elements to at least one receiver apparatus (REC-APP) comprising:

- encoding (TRA-S2-1) a first signal (PCDS) with a first coding before being processed by a first pre-distortion and amplification unit (TRA-APU-1),
- at least one second encoding (TRA-S2-2, ..., TRA-S2-N) of at least one second signal with at least one second coding before being processed by at least one second pre-distortion and amplification unit (TRA-APU-2, ..., TRA-APU-N),
- processing (TRA-S3-1) said first encoded signal (CDS) by said first pre-distortion and amplification unit (TRA-APU-1) for obtaining a first amplified pre-distorted encoded signal (ADS),
- processing (TRA-S3-2, ..., TRA-S3-N) said at least second encoded signal by said at least second pre-distortion and amplification unit (TRA-APU-2, ..., TRA-APU-N) for obtaining at least one second amplified pre-distorted encoded signal, and
- outputting (TRA-S4-1) said first amplified pre-distorted encoded signal as a first transmit signal (TS-1) to a first transmit antenna element, and
- outputting (TRA-S4-2, ..., TRA-S4-N) said at least one second amplified pre-distorted encoded signal as at least one second transmit signal (TS-2, ..., TS-N) to at least one second transmit antenna element,

**characterized in that** said first coding and said at least one second coding are adapted for being reversed by said at least one receiver apparatus (REC-APP) and said first coding and said at least one second coding are orthogonal codes.

2. Transmitter method (TRA-MET) according to claim 1, wherein said transmitter method (TRA-MET) further comprises:

- pre-coding (TRA-S1-1) a first data signal (DS) for obtaining a pre-coded data signal (PCDS) and wherein said encoding (TRA-S2-1) encodes said pre-coded data signal (PCDS), and
- pre-coding (TRA-S1-2, ..., TRA-S1-N) at least one second data signal for obtaining at least one second pre-coded data signal and wherein said at least one second encoding (TRA-S2-2, ..., TRA-S2-N) encodes said at least one second pre-coded data signal.

3. Transmitter method (TRA-MET) according to claim 1, wherein said orthogonal codes are determined by either of the following:

- Cholesky decomposition,
- singular value decomposition,
- Gram-Schmidt process,
- Housefolder transformation,
- Givens rotation.

4. Transmitter method (TRA-MET) according to claim 1 or claim 3, wherein said orthogonal codes are othonormal matrices.

5. Transmitter method (TRA-MET) according to any of the preceding claims, wherein said encoding (TRA-S1-1) of said first signal (PCDS) encodes all data to be transmitted by said first transmit antenna element and wherein said encoding (TRA-S1-2, ..., TRA-S1-N) of said at least one second signal encodes all data to be transmitted by said at least one second antenna element.

6. Transmitter method (TRA-MET) according to any of the preceding claims, wherein said transmitter method (TRA-MET) further comprises transmitting (TRA-S6) information of said first coding and of said at least one second coding to a single receiver apparatus (REC-APP) of said first transmit signal (TS-1) and of said at least second antenna signal (TS-2, ..., TS-N) or further comprises transmitting (TRA-S6) first information of said first coding to a first receiver apparatus (REC-APP) of said first transmit signal (TS-1) and at least second information of said at least second coding to at least one second receiver apparatus (REC-APP) of said at least one second transmit signal (TS-2, ..., TS-N).

7. Transmitter method (TRA-MET) according to any of the preceding claims 1 to 5, wherein said first coding and said at least one second coding are predefined at a transmitter apparatus (TRA-APP) executing said transmitter method (TRA-MET) and at at least one receiver apparatus (REC-APP) receiving at least one of said first transmit signal (TS-1) and said at least one second transmit signal (TS-2, ..., TS-N).

8. A receiver method (REC-MET) for radio frequency signals being transmitted from a transmitter apparatus (TRA-APP) via multiple antenna elements to a receiver apparatus (REC-APP), **characterized in that** said receiver method (REC-MET) comprises:

- receiving (REC-S1) a first transmit signal (TS-1) being encoded by a first coding for a first pre-distortion and amplification unit (TRA-APU-1) and being transmitted by a first transmit antenna element as a first received signal (RS-1) and at least one second transmit signal (TS-2, ..., TS-N) being encoded by at least one second coding for at least one second pre-distortion and amplification unit (TRA-APU-2, ..., TRA-APU-N) and being transmitted by at least one second transmit antenna element as at least one second received signal (RS-2, ..., RS-N), said first coding and said at least one second coding are orthogonal codes,
- a first decoding (REC-S2-1) of said first received signal (RS-1) for reversing said first coding, and
- at least one second decoding (REC-S2-2, ..., REC-S2-N) of said at least second received signal (RS-2, ..., RS-N) for reversing said at least one second coding.

9. Receiver method (REC-MET) according to claim 8, wherein, when a first decoding matrix is applied for said first decoding (REC-S2-1) and is orthonormal to at least one second decoding matrix being applied for said at least one second decoding (REC-S2-2, ..., REC-S2-N) and when a first coding matrix is applied by a transmitter method (TRA-MET) for coding said first transmit signal (TS-1) and is orthonormal to at least one second coding matrix being applied by said transmitter method (TRA-MET) for coding said at least one second transmit signal (TS-2, ..., TS-N), said first decoding matrix is equal to said first coding matrix and said at least one second decoding matrix is equal to said at least one second coding matrix.

10. Receiver method (REC-MET) according to claim 8, wherein, when a first decoding matrix is applied for said first decoding (REC-23-1) and is non-orthonormal to at least one second decoding matrix being applied for said at least one second decoding (REC-S2-2, ..., REC-S2-N) and when a first coding matrix is applied by a transmitter method (TRA-MET) for coding said first transmit signal (TS-1) and is non-orthonormal to at least one second coding matrix being applied by said transmitter method (TRA-MET) for coding said at least one second transmit signal (TS-2, ..., TS-N), either said first decoding matrix is inverse to said first coding matrix and said at least one second decoding matrix is inverse to said at least one second coding matrix or said first decoding matrix is equal to said first coding matrix, said at least one second decoding matrix is equal to said at least one second coding matrix and said receiver method (REC-MET) further comprises compensating (REC-S4) a processing gain of said at least one of said first decoding (REC-S2-1) and of said at least second decoding (REC-S2-2, ..., REC-S2-N).

11. Receiver method (REC-MET) according to any of the preceding claims 8 to 10, wherein said first decoding (REC-S2-1) and said at least one second decoding (REC-S2-2, ..., REC-S2-N) are executed at a beginning of a digital processing chain (REC-DPU).

12. A transmitter apparatus (TRA-APP) for transmitting radio frequency signals via multiple antenna elements to at least one receiver apparatus (REC-APP) comprising:

- means (CU-1) for encoding with a first coding a first signal (PCDT-1) before being processed by a first pre-distortion and amplification unit (TRA-APU-1),
- means for encoding with at least one second coding at least one second signal before being processed by at least one second pre-distortion and amplification unit (TRA-APU-2, ..., TRA-APU-N),
- said first pre-distortion and amplification unit (TRA-APU-1) for processing said first encoded signal (CDT-1) and for obtaining a first amplified pre-distorted encoded signal,
- said at least one second pre-distortion and amplification unit (TRA-APU-2, ..., TRA-APU-N) for processing said at least second encoded signal and for obtaining at least one second amplified pre-distorted encoded signal, and
- means (OU-1) for outputting said first amplified pre-distorted encoded signal as a first transmit signal (TS-1) to a first transmit antenna element, and
- means (OU-2, ..., OU-N) for outputting said at least one second amplified pre-distorted encoded signal as at least one second transmit signal (TS-2, ..., TS-N) to at least one second transmit antenna element,

**characterized in that** said first coding and said at least one second coding are adapted for being reversed by said at least one receiver apparatus (REC-APP) and said first coding and said at least one second coding are orthogonal codes.

13. A receiver apparatus (REC-APP) for radio frequency signals being transmitted from a transmitter apparatus (TRA-APP) via multiple antenna elements to said receiver apparatus (REC-APP), **characterized in that** said receiver apparatus (REC-APP) comprises:

- means (IN-U) for receiving as a first received signal (RS-1) a first transmit signal (TS-1) being encoded by a first coding for a first pre-distortion and amplification unit (TRA-APU-1) and being transmitted from a first transmit antenna element as a first received signal (RS-1) and for receiving as at least one second received signal (RS-2, ..., RS-N) at least one second transmit signal (TS2, ..., TS-N) being encoded by at least one second coding for at least one second pre-distortion and amplification unit (TRA-APU-2, ..., TRA-APU-N) and being transmitted from at least one second transmit antenna element, said first coding and said at least one second coding are orthogonal codes,
- means (DU1) for a first decoding of said first received transmit signal (DS1) for reversing said first coding, and
- means (DU2, ..., DUN) for at least one second decoding of said at least second received transmit signal (DS2, ..., DSN) for reversing said at least one second coding.

14. A network node (NN) comprising a transmitter apparatus (TRA-APP) according to claim 12 and/or a receiver apparatus (REC-APP) according to claim 13.

EP 2 882 154 A1

FIG. 1

21

TRA-MET

START

TRA-S1-1 | TRA-S1-2 | TRA-S1-N

| Pre-coding first signal | Pre-coding second signal | · · · | Pre-coding N-th signal |

TRA-S2-1 | TRA-S2-2 | TRA-S2-N | TRA-S5

| Encoding first signal | Encoding second signal | · · · | Encoding N-th signal | Transmitting information |

TRA-S3-1 | TRA-S3-2 | TRA-S3-N

| Pre-distorting first encoded signal | Pre-distorting second encoded signal | · · · | Pre-distorting N-th encoded signal |

TRA-S3-1-2 TRA-S3-1-1 | TRA-S3-2-2 TRA-S3-2-1 | TRA-S3-N-2 TRA-S3-N-1

| Amplifying first pre-distorted signal | Amplifying second Pre-distorted signal | · · · | Amplifying N-th pre-distorted signal |

TRA-S3-1-3 | TRA-S3-2-3 | TRA-S3-N-3

| Feeding back part of first amplified signal | Feeding back part of second amplified signal | · · · | Feeding back part of N-th amplified signal |

TRA-S4-1 | TRA-S4-2 | TRA-S4-N

| Outputting first transmit signal | Outputting second transmit signal | · · · | Outputting N-th transmit signal |

*FIG. 2*

END

FIG. 3

REC-S1

START    REC-MET

Receiving first transmit signal and at least second transmit signal

REC-S2-1    REC-S2-2    REC-S2-N

| Decoding first digital receive signal | Decoding second digital receive signal | . . . | Decoding N-th digital receive signal |

REC-S3

Non-orthonormal matrices and same matrices for coding and decoding applied?

Y    N

REC-S4    Compensating processing gain of decoding    REC-S5    Common processing steps

*FIG. 4*

NN

TRANC-APP

| REC-APP | TRA-APP |

**FIG. 5**

**EUROPEAN SEARCH REPORT**

Application Number

EP 13 30 6655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/313700 A1 (BAI CUNLONG [CA] BAI CHUNLONG [CA]) 13 December 2012 (2012-12-13) * abstract * * paragraphs [0001], [0004], [0005], [0017], [0020], [0025], [0033] * * claim 1 * * figures 3,4 * | 1-15 | INV. H04L25/03 H03F1/32 |
| X | MEHDI VEJDANI AMIRI ET AL: "Matrix-based orthogonal polynomials for MIMO transmitter linearization", COMPUTER AIDED MODELING, ANALYSIS AND DESIGN OF COMMUNICATION LINKS AND NETWORKS (CAMAD), 2010 15TH IEEE INTERNATIONAL WORKSHOP ON, IEEE, PISCATAWAY, NJ, USA, 3 December 2010 (2010-12-03), pages 57-60, XP031848687, ISBN: 978-1-4244-7634-3 * the whole document * | 1-15 | |
| X | BASSAM S A ET AL: "Crossover Digital Predistorter for the Compensation of Crosstalk and Nonlinearity in MIMO Transmitters", IEEE TRANSACTIONS ON MICROWAVE THEORY AND TECHNIQUES, IEEE SERVICE CENTER, PISCATAWAY, NJ, US, vol. 57, no. 5, 1 May 2009 (2009-05-01), pages 1119-1128, XP011255689, ISSN: 0018-9480 * the whole document * | 1-15 | TECHNICAL FIELDS SEARCHED (IPC) H04L H03F |

-/--

The present search report has been drawn up for all claims

| Place of search | Date of completion of the search | Examiner |
|---|---|---|
| Munich | 4 March 2014 | Murcia Martinez, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt

European Patent Office

Office européen des brevets

# EUROPEAN SEARCH REPORT

**Application Number**

EP 13 30 6655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | QIAN H ET AL: "Orthogonal Polynomials for Power Amplifier Modeling and Predistorter Design", IEEE TRANSACTIONS ON VEHICULAR TECHNOLOGY, IEEE SERVICE CENTER, PISCATAWAY, NJ, US, vol. 53, no. 5, 1 September 2004 (2004-09-01), pages 1468-1479, XP011119439, ISSN: 0018-9545, DOI: 10.1109/TVT.2004.832415 * the whole document * ----- | 1-15 | |

**TECHNICAL FIELDS SEARCHED (IPC)**

The present search report has been drawn up for all claims

| Place of search | Date of completion of the search | Examiner |
|---|---|---|
| Munich | 4 March 2014 | Murcia Martinez, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 30 6655

This annex lists the patent family members relating to the patent documents cited in the above-mentioned European search report.
The members are as contained in the European Patent Office EDP file on
The European Patent Office is in no way liable for these particulars which are merely given for the purpose of information.

04-03-2014

| Patent document cited in search report | Publication date | Patent family member(s) | Publication date |
|---|---|---|---|
| US 2012313700 A1 | 13-12-2012 | US 2012313700 A1<br>WO 2012168801 A1 | 13-12-2012<br>13-12-2012 |

EPO FORM P0459

For more details about this annex : see Official Journal of the European Patent Office, No. 12/82